Europäisches Patentamt

(19) European Patent Office

Office européen des brevets

(11) Publication number: **0 020 164**
**B1**

(12) **EUROPEAN PATENT SPECIFICATION**

(45) Date of publication of patent specification: **11.05.83**

(51) Int. Cl.³: **H 01 L 29/60,**
**H 01 L 29/78, H 01 L 29/62**

(21) Application number: **80301808.4**

(22) Date of filing: **30.05.80**

(54) Monolithic HVMOSFET array.

(30) Priority: **12.07.79 US 43283**
**30.05.79 US 43563**

(43) Date of publication of application:
**10.12.80 Bulletin 80/25**

(45) Publication of the grant of the patent:
**11.05.83 Bulletin 83/19**

(84) Designated Contracting States:
**DE FR**

(73) Proprietor: **XEROX CORPORATION**
**Xerox Square - 020**
**Rochester New York 14644 (US)**

(72) Inventor: **Ronen, Ram S.**
**207 Blanquita Way**
**Placentia, California 92670 (US)**

(74) Representative: **Weatherald, Keith Baynes et al,**
**European Patent Attorney Rank Xerox Patent**
**Department 338 Euston Road**
**London NW1 3BH (GB)**

(56) References cited:
**DE - A - 2 740 702**
**FR - A - 2 203 173**
**FR - A - 2 381 389**
**FR - A - 2 412 170**
**US - A - 3 339 128**

**IEEE TRANSACTIONS ON ELECTRON DEVICES,**
**vol. ED-15, no. 10, October 1968, New York,**
**USA, H. G. Dill: "A new insulated gate tetrode**
**with high drain breakdown potential and low**
**miller feedback capacitance", pages 717—728**

(56) References cited:
**TECHNICAL DIGEST 1977 INTERNATIONAL**
**ELECTRON DEVICES MEETING. December 5—**
**7, 1977, IEEE New York, USA, J. TIHANY et al.**
**"DIMOS- A novel IC technology with submicron**
**effective channel Mosfets", pages 399—401**
**IBM TECHNICAL DISCLOSURE BULLETIN, vol.**
**21, no. 8, January 1979, New York, USA T. A.**
**LARSEN et al. "Floating-gate device with dual-**
**control gates", pages 3368.**

Courier Press, Leamington Spa, England.

Monolithic HVMOSFET array

This invention relates to a high voltage metal oxide semiconductor field effect transistor (HVMOSFET) according to the first part of claim 1.

Previously, high voltage devices tended to be discrete and could be set up in an array by hardwiring them together on a printed circuit board. Extreme care had to be taken to separate the devices properly to keep their breakdown voltages high and to ensure that no fields from the high voltage devices interfered with adjacent low voltage logic circuits. With the need to integrate such devices arose the additional problem of a switch for connecting an active load in cascade with the device, but impossible because with an outer common electrode, the output electrode is effectively grounded.

It is an important object of the invention to employ integrated monolithic arrays of high voltage metal oxide semiconductor field effect transistors (HVMOSFETs) with split oxide having closed device geometry and grounded peripheries for use as switchable drivers able to source and sink non-steady state pulses.

An HVMOSFET according to the first part of claim 1 is known from DE—A—2 740 702. From IEEE Transactions on Electron Devices, Vol. ED-15, No. 10, October 1968, pp 717—728 a field effect transistor is known having two gate electrodes in closed loops around a drain electrode, with the inner gate electrode being positioned on a thick layer of metal oxide, and the outer gate electrode being positioned on a thin layer of metal oxide contiguous with the thick layer. IBM Technical Disclosure Bulletin, Vol. 21, No. 8, Jan. 1979, p 3368 discloses an FET having a floating field plate disposed between a gate electrode and the substrate for storing charges.

The present invention will now be described by way of example with reference to the accompanying drawings, in which:

Figure 1 is a plan view of a concentric grounded periphary HVMOSFET;

Figure 2 is a section through the HVMOSFET of Figure 1;

Figure 3 is a section through a HVMOSFET according to the invention having a horizontal floating field plate;

Figure 4 is a section through an alternative embodiment of the HVMOSFET device of Figure 3;

Figure 5 is a section through another embodiment of the invention;

Figure 6 is a section through an HVMOSFET having a semidielectric field plate, and

Figure 7 is a representative model of a HVMOSFET having an oxygen-doped polysilicon graded field HVMOSFET structure.

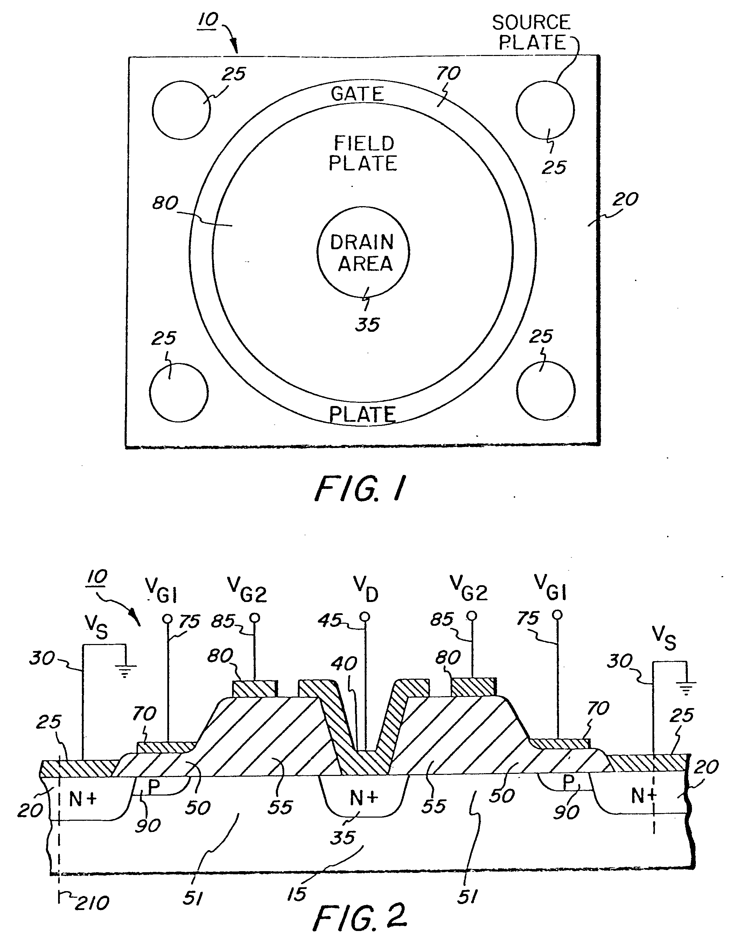

In the transistor shown in Figs. 1 and 2, a substrate 15 has an annulus 55 of metal oxide deposited on drift area 51, the inner part of the annulus being significantly thicker than the outer part 50. Two annular gate electrodes 70 and 80, with their respective leads 75 and 85, are deposited on the stepped surface of the oxide 55, with electrode 80 being for high voltage and electrode 70 for low voltage. The central drain electrode 40, with its lead 45, makes conductive contact with an N-doped region 35 of the substrate 15.

Positioned at four locations on the N-doped regions 20 of substrate 15 are source electrodes 25 connected through leads 30 to a voltage source, in this case earth. Positioned below the thinner oxide step 50 is a P-doped region 90 of the substrate, the region being contiguous with both the oxide and region 20.

In the embodiment of the invention shown in Figures 1 and 2, the HVMOSFET 10 is shown in complete concentricity with the source electrode 30 grounded. This acts to solve the interdevice isolation problem by setting the periphery of the HVMOSFET device 10 at ground, as is the substrate 15, thereby allowing neighboring devices actually to touch each other with relative impunity.

It will be appreciated that by grounding the source area 25 as described and as shown in Figures 1 and 2, one can also have an axis of symmetry 210 relative to an array 215 of HVMOSFET devices 10 in addition to the axis of symmetry relative to the center of the device.

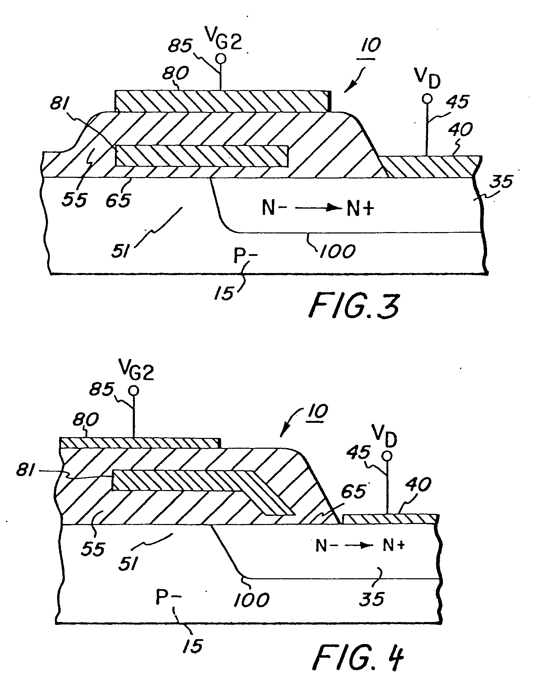

In another embodiment of the invention, as shown in Figure 3, an additional floating field plate 81 is interposed between the field plate 80 and the surface 65, so that hot carries can be injected into it by the field plate 80 and thereby minimize the field thereabout in the oxide 55. The floating field plate 81 should either be of polysilicon (poly) or a proper refractive metal such as tungsten or molybdenum.

In another embodiment, as shown in Figure 4, the floating field plate 81 may be a lipped annulus in configuration, thereby allowing tunnelling to occur at the drain area 35 and not over the junction 100 or the drift region 51. As the floating field plate gets further from the drain area 35, the oxide 55 underneath has to support a relatively higher field in the "off" condition of the device 10.

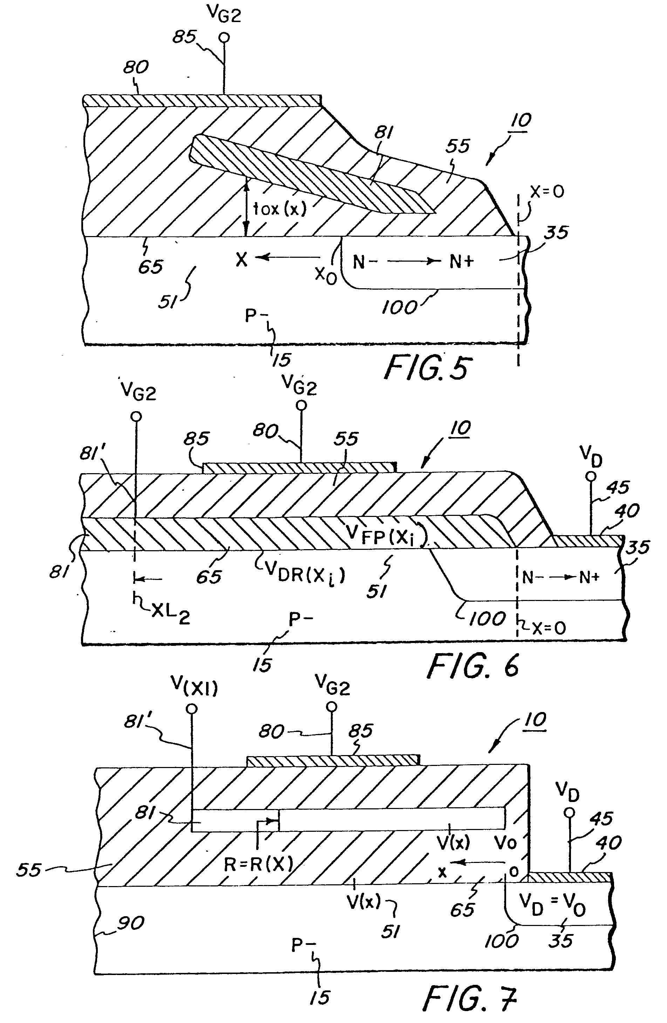

In yet a further embodiment, as shown in Figure 5, a frustoconical electrode 81 is positioned in oxide 55, with its distance from surface 65 (tox(x)) being proportional to its radial distance (X) from the axis of symmetry to prevent destructive oxide breakdown.

In another embodiment, as shown in Figure 6, to prevent hot electrons from becoming a reliability problem, a slightly conductive layer, such as a floating field plate 81, can replace the oxide 55, using $SiO_2$ or $Si_3N_4$, over the junction 100 and drift region 51. The plate 81 may be a semi-insulating polysilicon SiPOS such as oxygen doped polysilicon. The oxygen doped poly for the plate 81 can be put in direct contact with the surface 65 of the P-silicon substrate 15 or alternatively over a relatively thin oxide (not shown). Because of the plate's finite though relatively low conductivity, it may act as a very high resistance field plate 81, thereby avoiding the problem of hot electron injection and trapping in the oxide 55 near the drain area 35 as mentioned above. At the same time, the plate's relatively low conductivity can allow getting up a field at the surface 65 that is relatively almost perpendicular at the surface 65. As shown in Figure 7, to ensure a slow field drop and relatively perpendicular field lines at the surface 65 (equipotentials), an electrode 81' is connected to the semi-insulator plate 81 at X equals XL2, and the voltage at that point VG2 is set up so that VFP (Xi) is greater than or equal to VDR (Xi).

It will be noted that by combining a relatively high resistive plate 81 over the junction 100 and drift region 51, one can reduce tangential field components at the surface 65. Specifically, one can minimize (field potential) lines that cause crowding at the surface 65. In addition, combination of oxygen doped polysilicon or similar very high resistance material at plate 81 and a geometry factor/shape makes the lateral field drop from the drain area 35 to the channel 90 equal to the resistance drop in the SiPOS plate 81. Assuming a depletion region voltage drop of E(X) equals E(O)—9NaX/ESi, where Na and ESi are constants for a given substrate 15 type, and the potential distribution is $Q(X)=VO((1-X)/X)^2$, where $XO=X(Q=0)$, it will be noted that by making R(X) proportional to VX, it is possible to have a potential distribution in an R of the depletion region. In addition, by adjusting R(X), XO and V(X1) where $V_{G2}$ equals V(X1), one can adjust the field lines and voltage drops to eliminate local crowding and local avalanche. Likewise, a step at VO(X1) can help invert the surface 65 of the substrate 15 more quickly.

## Claims

1. A high voltage metal oxide semiconductor field effect transistor (HVMOSFET) (10) having, in an integrated array on a monolithic substrate (15), a source electrode (25), a drain electrode (40) and at least two intermediate gate electrodes (70, 80) of which one is positioned on a thicker layer of metal oxide than is the other, characterised in that the gate electrodes (70, 80) are in closed loops around the drain electrode (40); in that the inner gate electrode (80) is positioned on the thicker layer (55) of metal oxide, to function at high voltage; in that the outer gate electrode (70) is positioned on the thinner layer (50) of metal oxide contiguous with the thicker layer, to function at low voltage, and in that a field plate (81) is disposed between the inner gate electrode (80) and the substrate (15) and extends over a portion of the drain area (35) to capture injected carriers for reducing the concentration of field lines from the drain area.

2. The HVMOSFET of claim 1, characterised in that the field plate (81) is unconnected to any external terminal, so that its potential may float.

3. The HVMOSFET of claim 1 or 2, characterised in that the field plate is of polysilicon.

4. The HVMOSFET of claim 1 or 2, characterised in that the field plate is of a refractive metal.

5. The HVMOSFET of claim 4, characterised in that the refractive metal is tungsten.

6. The HVMOSFET of claim 4, characterised in that the refractive metal is molybdenum.

7. The HVMOSFET of claim 1, or any claim dependent therefrom, characterised in that the field plate is substantially parallel to the adjacent surface (65) of the substrate (15).

8. The HVMOSFET of claim 7, characterised in that the field plate has an integral frustoconical extension adjacent to the drain area (35) to enhance tunnelling in the drain area and inhibit it in the drift area (51) (Fig. 4).

9. The HVMOSFET of claim 1, or any claim dependent therefrom, characterised in that the field plate is in the form of a frustoconical ring for prevention of destructive oxide breakdown in the said layer of relatively-thick oxide (Fig. 5).

10. The HVMOSFET of claim 1, or any claim dependent therefrom, characterised in that the field plate is of a relatively-poor conductor.

11. The HVMOSFET of claim 3, characterised in that the field plate is of polysilicon that has been oxygen doped to be semi-insulating.

12. The HVMOSFET of claim 10 or 11, characterised in that field plate is in direct contact with a surface (65) of the substrate (Fig. 6).

13. The HVMOSFET of claim 1, or any of claims 3—12, characterised in that a terminal (81) extends from the field plate at the opposite end from that of the drain area for allowing the potential at any point in the plate to be greater than, or equal to, the drain potential in the drift area (Fig. 7).

## Patentansprüche

1. Hochspannungs-Metalloxyd-Halbleiter-Feldeffekttransistor (HVMOSFET) (10), der in einer integrierten Anordnung auf einem monolithischen Substrat (15) eine Quellenelektrode (25), eine Drain-Elektrode (40) und zumindest zwei Zwischen-Gate-Elektroden (70, 80) aufweist, von denen eine auf einer dickeren Schicht von Metalloxyd als die andere angeordnet ist, dadurch gekennzeichnet, daß die Gate-Elektroden (70, 80) in geschlossenen Schleifen um die Drain-Elektrode (40) gelegt sind; daß die innere Gate-Elektrode (80) auf der dickeren Schicht (55) von Metalloxyd angeordnet ist, um bei Hochspannung zu arbeiten; daß die äußere Gate-Elektrode (70) auf der dünneren Schicht (50) von Metalloxyd anschließend an die dickere Schicht angeordnet ist, um bei Niederspannung zu arbeiten und daß eine Feldplatte (81) zwischen der inneren Gate-Elektrode (80) und dem Substrat (15) angeordnet ist und sich über einen Teil des Drain-Bereichs (35) erstreckt, um injizierte Träger zu fangen, um die Konzentration von Feldlinien von dem Drain-Bereich zu reduzieren.

2. HVMOSFET nach Patentanspruch 1, dadurch gekennzeichnet, daß die Feldplatte (81) zu jeder externen Klemme unverbunden ist, so daß ihr Potential fleißen kann.

3. HVMOSFET nach Anspruch 1 oder 2, dadurch gekennzeichnet, daß die Feldplatte aus Polysilizium ist.

4. HVMOSFET nach Anspruch 1 oder 2, dadurch gekennzeichnet, daß die Feldplatte aus brechendem Material ist.

5. HVMOSFET nach Anspruch 4, dadurch gekennzeichnet, daß das brechende Material Wolfram ist.

6. HVMOSFET nach Anspruch 4, dadurch gekennzeichnet, daß das brechende Material Molybdän ist.

7. HVMOSFET nach Anspruch 1 oder einem davon abhängenden Anspruch, dadurch gekennzeichnet, daß die Feldplatte im wesentlichen parallel zur benachbaten Oberfläche (65) des Substrats (15) ist.

8. HVMOSFET nach Anspruch 7, dadurch gekennzeichnet, daß die Feldplatte eine integrale kegelstumpfförmige Ausweitung benachbart zum Drain-Bereich (35) besitzt, um das Durchtunneln in dem Drain-Bereich zu fördern und es in dem Driftbereich (51) zu blockieren (Fig. 4).

9. HVMOSFET nach Anspruch 1 oder einem davon abhängigen Anspruch, dadurch gekennzeichnet, daß die Feldplatte die Form eines kegelstumpfförmigen Ringes zum Verhindern eines zerstörenden Oxydzusammenbrechens in der genannten Schicht von verhältnismäßig dickem Oxyd besitzt (Fig. 5).

10. HVMOSFET nach Anspruch 1 oder einem davon abhängenden Anspruch, dadurch gekennzeichnet, daß die Feldplatte ein verhältnismäßig schlechter Leiter ist.

11. HVMOSFET nach Anspruch 3, dadurch gekennzeichnet, daß die Feldplatte aus Polysilizium ist, das sauerstoffdotiert worden ist, um halbisolierend zu sein.

12. HVMOSFET nach Anspruch 10 oder 11, dadurch gekennzeichnet, daß die Feldplatte in direktem Kontakt mit einer Oberfläche (65) des Substrats ist (Fig. 6).

13. HVMOSFET nach Anspruch 1 oder einem der Ansprüche 3 bis 12, dadurch gekennzeichnet, daß sich ein Anschluß (81) von der Feldplatte an dem dem Drain-Bereich gegenüberliegenden Ende wegerstreckt, um zu ermöglichen, daß das Potential an jedem Punkt in der Platte größer oder gleich dem Drain-Potential in dem Driftbereich ist (Fig. 7).

**Revendications**

1. Transistor à effet de champ à semiconducteur en oxyde métallique, à haute tension (MOSFET à haute tension) (10), ayant dans un réseau intégré sur un substrat monolithique (15), une électrode de source (25), un électrode de drain (40) et au moins deux électrodes intermédiaires de grille (70, 80) dont l'une est placée sur une couche plus épaisse d'oxyde métallique qui l'autre, caractérisé en ce que les électrodes de grille (70, 80) sont dans des boucles fermées autour de l'électrode de drain (40); l'électrode intérieure de grille (80) est placée sur la couche plus épaisse (55) d'oxyde métallique, de manière à fonctionner à haute tension; l'électrode extérieure de grille (70) est placée sur la couche plus fine (50) d'oxyde métallique contiguë à la couche plus épaisse, de manière à fonctionner à basse tension; et une plaque de champ (81) est disposée entre l'électrode intérieure de grille (80) et le substrat (15) et s'étend sur une partie de la zone de drain (35) pour capturer des proteurs injectés de manière à réduire la concentration des lignes de champ à partie de la zone de drain.

2. MOSFET à haute tension selon la revendication 1, caractérisé en ce que la plaque de champ (81) n'est pas reliée à une borne extérieure, de sorte que son potentiel peut flotter.

3. MOSFET à haute tension selon les revendication 1 ou 2, caractérisé en ce que la plaque de champ est en polysilicium.

4. MOSFET à haute tension selon les revendications 1 ou 2, caractérisé en ce que la plaque de champ est en métal réfracteur.

5. MOSFET à haute tension selon la revendication 4, caractérisé en ce que le métal réfracteur est le tungstène.

6. MOSFET à haute tension selon la revendication 4, caractérisé en ce que le métal réfracteur est le molybdène.

7. MOSFET à haute tension selon la revendication 1, ou l'une quelconque des revendications en dépendant, caractérisé en ce que le plaque de champ est sensiblement parallèle à la surface contiguë (65) du substrat (15).

8. MOSFET à haute tension selon la revendication 7, caractérisé en ce que la plaque de champ comporte une partie en prolongement tronconique en une pièce contiguë à la zone de drain (35) de manière à renforcer l'effet de tunnel dans la zone de drain et l'inhiber dans la zone de déplacement (51), (figure 4).

9. MOSFET à haute tension selon la revendication 1, où l'une quelconque des revendications en dépendant, caractérisé en ce que la plaque de champ à la forme d'un anneau tronconique pour éviter une rupture destructrice de l'oxyde dans la couche relativement épaisse d'oxyde (figure 5).

10. MOSFET à haute tension selon la revendication 1, ou l'une quelconque des revendications en dépendant, caractérisé en ce que la plaque de champ est constituée d'un matériau relativement peu conducteur.

11. MOSFET à haute tension selon la revendication 3, caractérisé en ce que la plaque de champ est en polysilicium qui a été dopé à l'oxygène de manière à être semi-isolante.

12. MOSFET à haute tension selon la revendication 10, ou la revendication 11, caractérisé en ce que la plaque de champ est en contact direct avec une surface (65) du substrat (figure 6).

13. MOSFET à haute tension selon la revendication 1, ou l'une quelconque des revendications 3 à 12, caractérisé en ce qu'une borne (81) s'étend à partir de la plaque de champ à l'extrémité opposée à celle de la zone de drain pour permettre au potentiel en n'importe quel point de la plaque d'être supérieur, ou égal, au potentiel de drain dans la zone de déplacement (figure 7).

*FIG. 1*

*FIG. 2*

FIG.3

FIG. 4

0 020 164

$V_{G2}$

85
80
81
55
10
X=0
$t_{ox}(x)$
35
65
X
$X_O$
N-  →  N+
100
51
P-
15

FIG. 5

$V_{G2}$    $V_{G2}$

81'
85
80
55
10
$V_D$
45
40
$V_{FP}(X_i)$
35
81
65  $V_{DR}(X_i)$
51
N- → N+
$XL_2$
100
X=0
P-
15

FIG. 6

$V(XI)$    $V_{G2}$

81'
80
85
10
81
$V_D$
45
40
$V(x)$  $V_O$
55
R=R(X)
x
o
65
$V(x)$
$V_D = V_O$
90
51
100  35
P-
15

FIG. 7

3